# EUROPÄISCHE PATENTANMELDUNG

(11) **EP 2 149 858 A1**
(43) Veröffentlichungstag der Anmeldung: **03.02.2010**
(21) Anmeldenummer: 09009723.9
(22) Anmeldetag: 28.07.2009
(51) Int. Cl.: G06K 19/077

(54) **Verfahren zur Herstellung einer Vorrichtung zur drahtlosen Kommunikation bzw. eines Prelaminats für eine solche Vorrichtung**

(30) Priorität: 30.07.2008 DE 102008035522
(71) Anmelder: Mühlbauer AG, 93426 Roding (DE)
(72) Erfinder: Brod, Volker, 93077 Bad Abbach (DE); Monser, Hans-Peter, 01129 Dresden (DE)
(74) Vertreter: Schneider, Andreas

(57) **Zusammenfassung**

Die Erfindung betrifft ein Verfahren zur Herstellung einer Vorrichtung zur drahtlosen Kommunikation, insbesondere einer kontaktlosen Karte, eines e-Paßports, eines Smart Labels oder dergleichen bzw. eines Prelaminats für eine solche Vorrichtung. Darüber hinaus betrifft die Erfindung ein Prelaminat sowie eine Vorrichtung zur drahtlosen Kommunikation. Das erfindungsgemäße Verfahren umfaßt die Schritte: Herstellen einer Antenne (2) durch Aufbringen einer Antennenstruktur auf ein Substrat (3) unter Verwendung eines additiven Verfahrens, insbesondere durch Metallabscheidung, wobei das Substrat (3) aus einem PVC- oder Polycarbonat-Material besteht, Herstellen eines Transponders (6) durch Verbinden eines ungehäusten Chips (5), mit der Antenne (2) durch eine Direktmontage, insbesondere unter Verwendung eines Flip-Chip-Verfahrens, und Herstellen der Vorrichtung oder des Prelaminats (1) für die Vorrichtung durch Verbinden des Transponders (6) mit weiteren Schichten (8, 9, 10) unter Verwendung eines Laminierverfahrens, wobei zumindest eine der unmittelbar an das Substrat (3) angrenzenden weiteren Schichten (8, 10) aus dem gleichen Material besteht wie das Substrat (3).

## Beschreibung

Die Erfindung betrifft ein Verfahren zur Herstellung einer Vorrichtung zur drahtlosen Kommunikation, insbesondere einer kontaktlosen Karte, eines e-Paßports, eines Smart Labels oder dergleichen bzw. eines Prelaminats für eine solche Vorrichtung. Darüber hinaus betrifft die Erfindung ein Prelaminat sowie eine Vorrichtung zur drahtlosen Kommunikation.

Drahtlose Kommunikation bei den oben genannten Produkten erfolgt heutzutage zumeist unter Einsatz der RFID (Radio Frequency Identification)-Technologie, so daß nachfolgend - ohne daß dies als Einschränkung zu verstehen ist - auch von RFID-Chip gesprochen wird.

Anwendungen mit RFID-Funktionalität in kontaktlosen Kunststoffkarten gewinnen weltweit immer mehr an Bedeutung. Es ist oftmals erwünscht, daß derartige RFID-Produkte neben der RFID-Funktionalität, also der Möglichkeit, über ein kontaktloses RFID-Interface mit dem RFID-Chip Daten austauschen und in einem in dem RFID-Produkt integrierten Speicher ablegen zu können, zusätzliche, zumeist anwendungsspezifische Funktionalitäten aufweisen. Beispielsweise sollen Chipkarten mit einem Photo des Kartenbesitzers auf der Kartenoberfläche versehen sein oder mit Sicherheitsmerkmale, wie Hologramme, Lasergravuren oder dergleichen ausgestattet sein.

Aus diesen Anforderungen heraus ergeben sich für diese RFID-Produkte bestimmte Vorgaben hinsichtlich des Aufbaus und des Herstellungsprozesses derartiger RFID-Produkte.

Vorrichtungen zur drahtlosen Kommunikation, insbesondere kontaktlose Karten, e-Paßports, Smart Label oder dergleichen sind zumeist aus einer Vielzahl von Schichten aufgebaut. Vorzugsweise bestehen diese Schichten im wesentlichen aus Kunststoffmaterialien und werden unter Verwendung einer Laminiertechnik miteinander verbunden. Die einzelnen Schichten werden dabei zusammengeschweißt, wobei dies vorzugsweise mit Hilfe beheizbarer Laminierwalzen und/oder Laminierpressen unter Druck geschieht.

Vorrichtungen zur drahtlosen Kommunikation weisen zumindest einen Halbleiterchip (Chip), also ein elektronisches Bauelement mit wenigstens einer integrierten elektronischen Schaltung, und eine mit dem Chip verbundene Antennenspule (Antenne) auf. Die Antenne wird dabei passend zu dem gewählten Chip und entsprechend der eingesetzten RFID-Technologie (HF oder UHF) ausgeführt. Bei dem Chip kann es sich um einen ungehäusten Chip (bare die) oder einen gehäusten Chip (Chipmodul) handeln. Je nach Anwendung wird ein RFID-Chip mit oder ohne Sicherheitsmerkmale, mit einem großen oder kleinen Datenspeicher bzw. mit HF- oder UHF-Interface eingesetzt. Chip und Antenne bilden einen Transponder und befinden sich dabei in der Regel auf einem gemeinsamen Substrat, der Transponderschicht, die auch als "Inlay" oder "Inlet" bezeichnet wird.

Häufig wird die Transponderschicht zusammen mit weiteren Schichten, wie beispielsweise Kompensationsschichten, Boden- und Deckschichten usw., mit Hilfe eines Laminierprozesses zu einem Schichtverbund, dem sogenannten Prelaminat, verarbeitet. Das Prelaminat als Zwischenprodukt kann dann in weiteren Verfahrensschritten zu einer kontaktlosen Chipkarte, einem e-Paßport, einem Smart Label oder dergleichen, weiterverarbeitet werden. Es ist aber auch eine unmittelbare Herstellung dieser Produkte ohne Prelaminat möglich.

Zur Herstellung der Transponderschicht für ein Prelaminat oder eine Vorrichtung zur drahtlosen Kommunikation werden in der Regel zunächst die Antennenstrukturen auf ein Kunststoffsubstrat aufgebracht. Anschließend erfolgt die Montage des Chips. Für das Herstellen der Antenne sind ebenso wie für die Chipmontage verschiedene Verfahren bekannt, auf die nachfolgend näher eingegangen werden soll.

Für die Montage von ungehäusten Chips werden meist Techniken der Direktmontage angewendet, bei denen die ungehäusten Chips vom Wafer direkt auf das Substrat aufgebracht werden. Hier hat sich die sogenannte Flip-Chip-Technik als besonders vorteilhaft etabliert, bei der die ungehäusten Chips mit der aktiven Seite zum Substrat hin montiert und gleichzeitig über Klebstoffbumps elektrisch kontaktiert werden. Die bei diesem Montageverfahren hergestellten Klebeverbindungen dienen sowohl zur mechanischen Fixierung der Chips auf dem Substrat, als auch zur Herstellung eines elektrischen Kontaktes zwischen den Kontaktanschlüssen des Chips einerseits und den Anschlüssen der sich bereits auf dem Substrat befindenden Antenne andererseits. Die zur Anwendung kommenden anisotropischen Kleber benötigen dabei Aushärtezeiten von mehreren Sekunden bei vergleichsweise hohen Temperaturen (ca. 150°C-200°C). Bei Substraten aus Materialien mit niedriger Schmelztemperatur, beispielsweise Polyvinylchlorid (PVC) mit einer Schmelztemperatur von ca. 80°C, besteht damit die Gefahr einer irreversiblen Deformation des Substrates. Bei der Flip-Chip-Montage von ungehäusten Chips besteht das Substrat daher heute meist aus bis zu ca. 200°C temperaturstabilisierter Folie aus einem Polyethylenterephthalat (PET-Folie).

Die Herstellung der Antenne auf PET-Folie erfolgt in der Regel mit Hilfe von Subtraktiv-Verfahren. Üblicherweise erfolgt das Aufbringen der Antennenstrukturen durch lokales chemisches Entfernen einer auf dem Substrat aufgeklebten Kupfer- oder Aluminiumfolie, beispielsweise durch Ätzen mit Schwefelsäure.

Ein wesentliches Qualitätskriterium bei der Lamination ist die Haftfestigkeit der Schichten. Die beste Haftfestigkeit wird erreicht, wenn die zu laminierenden Schichten aus identischen Kunststoffmaterialien bestehen. Bestehen also die übrigen Schichten eines Prelaminats oder einer kontaktlosen Chipkarte oder dergleichen aus einem PVC-Material, was bei den heute bekannten Produkten den Regelfall darstellt, ist ein Laminieren des PET-Antennensubstrats nur mittels einer speziellen, zwischen dem PET-Inlet und den benachbarten PVC-Schichten eingebrachten Heißklebefolie (HAF-Folie, "heatsealable adhesive film") möglich bzw. nur dann, wenn die PET-Folie vor dem Laminieren mit PVC-Material beschichtet wird. Dieses Verfahren ist sehr aufwendig und vergleichsweise fehleranfällig.

Bestehen die übrigen Schichten aus einem Polycarbonatmaterial, ist ein Laminieren mit einem PET-Antennensubstrats wegen der fehlenden Haftfestigkeit zwischen den aus unterschiedlichen Materialien bestehenden Schichten überhaupt nicht möglich. Dies ist sehr nachteilig, da es oftmals besonders wünschenswert ist, Polycarbonatmaterial zu verwenden. So ist beispielsweise das Aufbringen von bestimmten hochqualitativen Sicherheitsmerkmalen, wie das Aufbringen des Bildes des Kartenbesitzers zur Personalisierung der Karte mittels Laser, bei Verwendung von Polycarbonatmaterial besonders gut möglich.

Selbst wenn man die Verwendung von Polycarbonat als Material für das Antennensubstrat in Erwägung ziehen würde, was aufgrund der hohen Temperaturen bei der Aushärtung des Klebers im Flip-Chip-Verfahren ausgeschlossen ist, wäre es aufgrund der verwendeten Ätz-Technik nicht möglich, eine stabile Verbindung des Polycarbonat-Substrates mit einer benachbarten Polycarbonatschicht zu erreichen. Denn der oben beschriebene Ätzprozeß hinterläßt zwischen den Antennenstrukturen Reste des Klebers, der für die Befestigung der Kupferfolie auf dem Substrat benötigt wurde. Diese Kleberreste verhindern in der Regel eine stabile Verbindung bei dem späteren Laminieren.

Eine Aufgabe der vorliegenden Erfindung ist es daher, ein Verfahren zur Herstellung qualitativ besonders hochwertiger Prelaminate bzw. kontaktloser Chipkarten, e-Paßports oder dergleichen bereitzustellen, bei welchem der Einsatz der Flip-Chip-Technologie möglich ist.

Diese Aufgabe wird durch ein Verfahren nach Anspruch 1 gelöst. Vorteilhafte Ausführungen der Erfindung sind in den Unteransprüchen angegeben.

Danach umfaßt das Verfahren die folgenden Schritte:
- Herstellen einer Antenne durch Aufbringen einer Antennenstruktur auf ein Substrat unter Verwendung eines additiven Verfahrens, insbesondere durch Metallabscheidung, wobei das Substrat aus einem PVC- oder Polycarbonat-Material besteht,
- Herstellen eines Transponders durch Verbinden eines ungehäusten Chips mit der Antenne durch eine Direktmontage, insbesondere unter Verwendung eines Flip-Chip-Verfahrens, und
- Herstellen der Vorrichtung oder des Prelaminats für die Vorrichtung durch Verbinden des Transponders mit weiteren Schichten unter Verwendung eines Laminierverfahrens, wobei zumindest eine der unmittelbar an das Substrat angrenzenden weiteren Schichten aus dem gleichen Material besteht wie das Substrat.

Besonders vorteilhaft kann die Erfindung angewendet werden bei der Herstellung von Schichtprodukten aus Kunststoff, insbesondere aus PVC oder Polycarbonat, mit RFID-Funktionalität. Dies betrifft beispielsweise, aber nicht ausschließlich kontaktlose Chipkarten, einschließlich Chipkarten mit Identifikationsfunktion, Chipkarten mit Zahlungsfunktion und dergleichen, e-Paßports, Smart Label etc. Die vorliegende Erfindung betrifft dabei ausschließlich die Verwendung ungehäuster Chips. Dabei können verschiedene Antennentypen zum Einsatz kommen, so beispielsweise mit HF- und UHF-Antennen (13,56 MHz bzw. 860-960 MHz).

Eine Grundidee der Erfindung ist es, für das Antennensubstrat das gleiche Material zu verwenden, wie für die restliche Produktumgebung, nämlich PVC oder Polycarbonat, um eine optimale Haftfestigkeit der Schichten nach dem Laminationsprozeß zu erreichen. Um dies zu ermöglichen, kommt erfindungsgemäß eine additive Technologie bei der Herstellung der Antenne zum Einsatz. Bei der Montage der ungehäusten RFID-Chips mit Hilfe der Flip-Chip-Technik kommen darüber hinaus Kleber mit niedrigen Aushärtetemperaturen zum Einsatz. Die Aushärtetemperaturen sind hierbei, in Anpassung u.a. an die Substrateigenschaften, so niedrig gewählt, daß das Substratmaterial (hier Polycarbonat oder PVC) während des Flip-Chip-Montageprozesses einerseits nicht unzulässig erweicht wird, andererseits aber eine ausreichende Aushärtung des Klebers gewährleistet ist.

Bei der eingesetzten Additivtechnik werden die Antennenstrukturen vorzugsweise durch Abscheidung von Antennenmaterial, meist Kupfer, auf das Substrat, genauer gesagt auf eine auf das Substrat gedruckte Schicht aufgebracht. Alternative Verfahren der Additivtechnik sind das Aufbringen des elektrisch leitfähigen Antennenmaterials auf das Substrat durch stromlose Abscheidung (electroless plating), Beschichten, insbesondere Plasmabeschichten, Sputtern, Bedampfen und Bestäuben. Gegenüber anderen Verfahren zeichnet sich die Additivtechnik durch eine vergleichsweise einfache Handhabung aus.

Je nachdem, welches additive Verfahren angewendet werden, und ob HF- oder UHF-Technologie verwendet wird, kann die auf das Substrat aufgebrachte Antenne in unterschiedlichen Schichtstärken hergestellt werden.

Die Anwendung einer additiven Antennentechnologie gewährleistet eine qualitativ hochwertige Laminierung der Schichten von Prelaminat oder Endprodukt. Dies wird insbesondere dadurch erreicht, daß das Aufbringen der Antennenstruktur auf das Substrat in einer Art und Weise erfolgt, daß die Oberfläche des Substrats abgesehen von der aufgebrachten Antennenstruktur frei liegt. Verschmutzungen der Kunststoffoberfläche durch Kleberreste oder dergleichen sind damit ausgeschlossen. Mit anderen Worten wird - im Gegensatz zu der Ätztechnik - nur an solchen Stellen Antennenmaterial (beispielsweise Kupfer) aufgebracht, an denen tatsächlich eine Antennenstruktur vorgesehen ist.

Mit der vorliegenden Erfindung wird - insbesondere im Hinblick auf den Einsatz einer additiven Antennentechnologie - ein Herstellungsverfahren für Prelaminate oder Vorrichtungen zur drahtlosen Kommunikation bereitgestellt, das für die Montage von ungehäusten Chips besonders gut geeignet ist. Das Herstellen des Transponders erfolgt daher durch eine Direktmontage eines ungehäusten RFID-Chips (direct chip attach), vorzugsweise unter Verwendung eines Flip-Chip-Verfahrens. Es können aber auch andere Direktmontageverfahren zum Einsatz kommen.

Während bei den genannten Anwendungen bisher eine Lamination mit Schichten gleichen Materials nur mit Hilfe der sogenannten Drahtverlegetechnik und ausschließlich für gehäuste Chips, sogenannte Chipmodule möglich war, ist es durch die vorliegende Erfindung erstmals möglich, mit Hilfe eines Direktmontageverfahrens ungehäuste Chips in einem Laminationsprodukt aus Schichten gleichen Materials zu integrieren. Damit wird das Herstellungsverfahren für derartige Produkte bzw. entsprechende Prelaminate gegenüber der Drahtverlegetechnik bedeutend schneller und produktiver.

Von Vorteil ist, daß das angegebene Verfahren grundsätzlich auch für Chipmodule angewendet werden kann. Die Erfindung kann mit anderen Worten technologieübergreifend eingesetzt werden.

Ein wesentlicher Vorteil einer Herstellung der Antennen auf einem Substrat aus PVC oder Polycarbonat mittels additiver Technik ist außerdem die erreichbare Flexibilität. So können die Antennen hinsichtlich ihrer Geometrie bzw. ihrer elektrischen Eigenschaften (wie bspw. Lesereichweite) an die Applikationsanforderungen angepaßt werden. Beispielsweise können zweilagig erstellte, d.h. auf gegenüberliegenden Seiten des Kunststoffsubstrats angeordnete, Antennen helfen, Platz einzusparen.

Vorrichtungen zur drahtlosen Kommunikation im Sinne der Erfindung sind nicht auf Chipkarten oder dergleichen beschränkt. So kann die Vorrichtung beispielsweise neben einem Halbleiterchip auch eine Batterie oder ein anderes elektronisches Bauteil oder aber ein Display, eine Eingabevorrichtung etc. aufweisen. Typische Beispiele für derartige Vorrichtungen sind Multifunktionskarten mit einem Display zum Ablesen von Informationen oder Karten mit Batterien für aktive Schaltungen, wie beispielsweise Sensoren usw.

Ein Ausführungsbeispiel der Erfindung wird nachfolgend anhand der Herstellung eines Prelaminats und unter Bezugnahme auf die Zeichnungen näher erläutert. Hierbei zeigen:

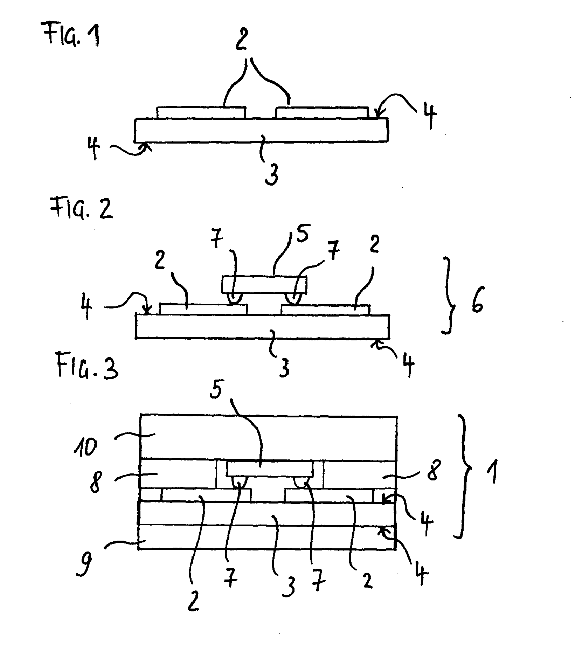

- Fig. 1: eine schematische Schnittdarstellung eines Antennensubstrats mit aufgebrachter Antenne,
- Fig. 2: eine schematische Schnittdarstellung eines Transponders,
- Fig. 3: das fertige Prelaminat.

Sämtliche Figuren sind nicht maßstabsgemäß und zeigen die Erfindung lediglich schematisch und mit ihren wesentlichen Bestandteilen. Gleiche Bezugszeichen entsprechen dabei Elementen gleicher oder vergleichbarer Funktion.

Zur Herstellung des Prelaminats 1 erfolgt zunächst die Herstellung einer Antenne 2 durch Aufbringen einer Antennenstruktur auf ein Substrat 3 unter Verwendung eines additiven Verfahrens, vorzugsweise eines an sich aus dem Stand der Technik bekannten Beschichtungsverfahrens. Hierzu wird zunächst entsprechend der späteren Antennenstruktur eine Schicht auf das Substrat 3 aufgedruckt, auf die dann in einem nächsten Schritt Kupfer abgeschieden wird. Dadurch wird nur an solchen Stellen des Substrats 3 Kupfer aufgebracht, an denen tatsächlich eine Antennenstruktur vorgesehen ist. Die übrige Oberfläche 4 des Substrats 3 liegt frei. Bei dem Substrat 3 handelt es sich um ein als Folie vorliegendes Polycarbonat-Substrat.

In einem nächsten Prozeßschritt wird durch Aufbringen eines ungehäusten RFID-Chips 5 auf die Antenne 2 mittels einer Flip-Chip-Technik ein Transponder 6 hergestellt. Aufgrund der Verwendung eines Polycarbonatsubstrats 2 unterscheidet sich die hier angewendete Technik von herkömmlichen Flip-Chip-Verfahren dadurch, daß ein Kleber 7 zum Einsatz, die bei Prozeßtemperaturen unterhalb von 130°C bei einer Einwirkzeit von vorzugsweise ca. 8 bis 15 Sekunden aushärtet. Dabei wird das Polycarbonat-Folienmaterial erweicht. Der RFID-Chip 5 wird aus diesem Grund mit sehr kleinen Bondkräften (ca. 0,5-1N) ausgehärtet und dadurch mit der Antenne 2 verbunden. Anschließend erfolgt in einem an sich aus dem Stand der Technik bekannten Laminierungsprozeß die Herstellung des Prelaminats 1, wobei sowohl eine Kompensationsschicht, als auch eine Bodenschicht 9 und eine Deckschicht 10 aus dem gleichen Polycarbonat-Material bestehen, wie das noch immer freiliegende Antennensubstrat 4, so daß eine sehr gute Haftfestigkeit der Schichten erzielt werden kann. Die Kompensationsschicht 8 gleicht dabei die Bauteilhöhe des RFID-Chips 5 im Aufbau des Prelaminats 1 aus, damit der Körper des Prelaminats 1 bei der Lamination des gesamten Lagenverbundes nicht in dem Bereich uneben wird, wo sich der RFID-Chip 5 befindet.

Mit dem gleichen Verfahren kann auch ein Prelaminat 1 hergestellt werden, bei dem das Antennensubstrat und die übrigen Schichten aus einem PVC-Material bestehen.

Das Prelaminat 1 kann dann in weiteren Verfahrensschritten zu einem vollständigen RFID-Produkt, beispielsweise einer kontaktlosen Chipkarte, weiterverarbeitet werden.

Die oben geschilderten Verfahrensschritte werden auch durchgeführt, wenn kein Prelaminat 1, sondern ein vollständiges RFID-Produkt direkt, d.h. ohne das Zwischenprodukt Prelaminat 1, hergestellt wird. Es ändern sich dann beispielsweise Art und Anzahl der zu laminierenden Schichten. Beispielsweise können zwischen der Kompensationsschicht 8 und der Deckschicht 10 einerseits und zwischen dem Substrat 3 und der Bodenschicht 9 andererseits bedruckte und/oder transparente Folien eingefügt werden. Alle in der Beschreibung, den nachfolgenden Ansprüchen und der Zeichnung dargestellten Merkmale können sowohl einzeln als auch in beliebiger Kombination miteinander erfindungswesentlich sein.

### Bezugszeichenliste

- 1: Prelaminat
- 2: Antenne
- 3: Substrat
- 4: Substratoberfläche
- 5: RFID-Chip
- 6: Transponder
- 7: Kleber
- 8: Kompensationsschicht
- 9: Bodenschicht
- 10: Deckschicht

## Patentansprüche

1. Verfahren zur Herstellung einer Vorrichtung zur drahtlosen Kommunikation, insbesondere einer kontaktlosen Karte, eines e-Paßports, eines Smart Label oder dergleichen bzw. eines Prelaminats (1) für eine solche Vorrichtung,
mit den Schritten:
- Herstellen einer Antenne (2) durch Aufbringen einer Antennenstruktur auf ein Substrat (3) unter Verwendung eines additiven Verfahrens, insbesondere durch Metallabscheidung, wobei das Substrat (3) aus einem PVC- oder Polycarbonat-Material besteht,
- Herstellen eines Transponders (6) durch Verbinden eines ungehäusten Chips (5) mit der Antenne (2) durch eine Direktmontage, insbesondere unter Verwendung eines Flip-Chip-Verfahrens, und
- Herstellen der Vorrichtung oder des Prelaminats (1) für die Vorrichtung durch Verbinden des Transponders (6) mit weiteren Schichten (8, 9, 10) unter Verwendung eines Laminierverfahrens, wobei zumindest eine der unmittelbar an das Substrat (3) angrenzenden weiteren Schichten (8, 10) aus dem gleichen Material besteht wie das Substrat (3).

2. Verfahren nach Anspruch 1, wobei das Aufbringen der Antennenstruktur auf das Substrat (3) derart erfolgt, daß die Oberfläche (4) des Substrats (3) abgesehen von der aufgebrachten Antennenstruktur frei liegt.

3. Verfahren nach Anspruch 1 oder 2, wobei bei der Herstellung des Transponders (6) mit einem Flip-Chip-Verfahren die Prozeßtemperatur 130°C nicht übersteigt.

4. Verfahren nach einem der Ansprüche 1 bis 3, wobei bei der Herstellung des Transponders (6) mit einem Flip-Chip-Verfahren der Chip (5) mit Bondkräften unter 1N ausgehärtet wird.

5. Verfahren nach einem der Ansprüche 1 bis 3, wobei alle weiteren Schichten der Vorrichtung bzw. des Prelaminats (1) aus dem gleichen Material bestehen wie das Substrat (3).

6. Verfahren nach einem der Ansprüche 1 bis 5, wobei der Chip (5) ein RFID-Chip ist.

7. Verfahren nach einem der Ansprüche 1 bis 6, wobei die Antenne (2) eine HF- oder UHF-Antenne ist.

8. Prelaminat (1) für eine Vorrichtung zur drahtlosen Kommunikation, insbesondere eine kontaktlose Karte, einen e-Paßport, ein Smart Label oder dergleichen, mit einem mit weiteren Schichten (8, 9, 10) unter Verwendung eines Laminierverfahrens verbundenen Transponder (6), welcher durch Verbinden eines Chips (5) mit einer Antenne (2) hergestellt ist, die durch Aufbringen einer Antennenstruktur auf ein Substrat (3) unter Verwendung eines additiven Verfahrens, insbesondere durch Metallabscheidung, hergestellt ist, wobei das Substrat (3) aus einem PVC- oder Polycarbonat-Material besteht, und wobei zumindest eine der unmittelbar an das Substrat (3) angrenzenden weiteren Schichten (8, 10) aus dem gleichen Material besteht wie das Substrat (3).

9. Vorrichtung zur drahtlosen Kommunikation, hergestellt unter Verwendung eines Prelaminats (1) nach Anspruch 8.

10. Vorrichtung zur drahtlosen Kommunikation, insbesondere kontaktlose Karte, e-Paßport, Smart Label oder dergleichen, mit einem mit weiteren Schichten (8, 9, 10) unter Verwendung eines Laminierverfahrens verbundenen Transponder (6), welcher durch Verbinden eines Chips (5) mit einer Antenne (2) hergestellt ist, die durch Aufbringen einer Antennenstruktur auf ein Substrat (3) unter Verwendung eines additiven Verfahrens, insbesondere durch Metallabscheidung, hergestellt ist, wobei das Substrat (3) aus einem PVC- oder Polycarbonat-Material besteht, und wobei zumindest eine der unmittelbar an das Substrat (3) angrenzenden weiteren Schichten (8, 10) aus dem gleichen Material besteht wie das Substrat (3).
